# EUROPÄISCHE PATENTSCHRIFT

(11) **EP 0 690 559 B1**
(45) Veröffentlichungstag und Bekanntmachung des Hinweises auf die Patenterteilung: **10.05.2000**
(21) Anmeldenummer: 95109560.3
(22) Anmeldetag: 20.06.1995
(51) Int. Cl.: H03B 19/14, H03K 5/00

(54) **Schaltungsanordnung zur Frequenzvervielfachung**
Circuit for frequency multiplying
Circuit de multiplication de fréquence

(30) Priorität: 29.06.1994 DE 4422802
(43) Veröffentlichungstag der Anmeldung: 03.01.1996
(73) Patentinhaber: SIEMENS AKTIENGESELLSCHAFT, 80333 München (DE)
(72) Erfinder: Unterricker, Reinhold, Dr. Dipl.-Ing., D-81369 München (DE)

(56) Entgegenhaltungen:
- WO-A-91/12666
- ELECTRONICS LETTERS, Bd.27, Nr.4, 14. Februar 1991, STEVENAGE, HERTS., GB Seiten 309 - 310 A. W. BUCHWALD ET AL: 'High-speed voltage-controlled oscillator with quadrature outputs'
- PATENT ABSTRACTS OF JAPAN vol. 13, no. 295 (E-783) (3643) 7. Juli 1989 & JP-A-01 074 808 (MITSUBISHI ELECTRIC CORP) 20. März 1989

## Beschreibung

Die Erfindung betrifft eine Schaltungsanordnung zur Frequenzvervielfachung einer in einem Ringoszillator erzeugten Referenzfrequenz.

Bei einer Schaltungsanordnung der genannten Art werden die jeweils an den Ausgängen der einen Ringoszillator bildenden Signalverzögerungsstufen anliegenden Signalpegel an die Eingänge einer mit vorzugsweise aus Exclusiv-Oder(XOR) Logikelementen gebildeten Frequenzvervielfachungsschaltung weitergeleitet. Bei den bisher bekannten Schaltungsanordnungen zur Frequenzvervielfachung ist es von Nachteil, daß aufgrund der technologischen Ausprägungen, die beispielsweise der asymmetrische Aufbau eines Exclusiv-Oder Logikelementes mit sich bringt, eine Erhöhung des Faktors einer Frequenzvervielfachung erschwert wird. Des weiteren wird durch die Vielzahl der in den Schaltungsanordnungen verwendeten Logikelemente bzw. Schaltungsgatter eine Erhöhung des Pegelwechsels des Ausgangssignals erheblich eingeschränkt, darüber hinaus begrenzt ein bei diesem Schaltungstyp entstehender Phasenjitter bei steigenden Schaltfrequenzen eine weitere Erhöhung der Frequenzvervielfachung.

Entstehende schaltungstechnische Verzögerungszeiten müssen mit zusätzlichen in die Schaltungsanordnung zu integrierenden Ergänzungsschaltungen ausgeglichen werden. Schaltungstechnische Probleme bei der Temperaturkompensation sowie bei der Spannungsversorgung erschweren jedoch eine Integration der Ergänzungsschaltungen. Eine Schaltungsanordnung zur Frequenzvervielfachung mit Ergänzungsschaltung ist zum Beispiel aus Electronics Letters, 14. Feb. 91, Vol. 27, No. 4, S. 309-310 bekannt. Diese Schaltungsanordnung zur Frequenzvervielfachung weist jedoch neben dem Nachteil eines großen Aufwandes an Logikelementen den weiteren Nachteil auf, daß der Strombedarf der Schaltungsanordnung sehr hoch ist. Des weiteren wird aufgrund der benötigten Vielzahl der aus Logikelementen gebildeten Schaltkreisstufen eine schaltungstechnische Optimierung und damit eine Erhöhung der Pegelwechselfrequenz des Ausgangssignals erschwert.

Der Erfindung liegt die Aufgabe zugrunde, eine Schaltungsanordnung der eingangs genannten Art anzugeben, bei der die genannten Nachteile vermieden werden.

Diese erfindungsgemäße Aufgabe wird durch die kennzeichnenden Merkmale des Anspruchs 1 gelöst.

Die Erfindung bringt in Verbindung mit der Verwendung von Differenzverstärkern, deren Aufbau symmetrisch ausgestaltet ist, den Vorteil mit sich, daß zu einer Erlangung einer hohen, ungeradzahligen Frequenzvervielfachung eine geringere Anzahl von Schaltkreisstufen mit einer deutlich geringeren Anzahl von Logikelementen notwendig ist.

Eine vorteilhafte Ausgestaltung der Erfindung ist es, daß sie in einfachster Weise auf einen Logikbaustein als integrierte Schaltung implementiert werden kann, wobei die Entwicklungsschritte zur Herstellung der Schaltungsanordnung gegenüber der herkömmlichen Schaltungstechnik deutlich reduziert sind und höchste Schwingfrequenzen erzeugt werden können.

Die erfindungsgemäße Schaltungsanordnung zur Frequenzvervielfachung einer durch den Ringoszillator erzeugten Referenzfrequenz beruht darauf, daß jeweils die Ausgangssignale sowie die negierten Ausgangssignale der einen Ringoszillator bildenden invertierenden Signalverzögerungsglieder an die Eingänge von Differenzverstärkern weitergeleitet werden. Die Anzahl der Differenzverstärker entspricht der Anzahl der Signalverzögerungsglieder. Die homologen Ausgangssignale aller Differenzverstärker werden jeweils zusammengefaßt, z.B. an einem gemeinsamen Widerstandselement, an welchem das Ausgangssignal bzw. das negierte Ausgangssignal mit vervielfachter Frequenz entsteht.

Vorteilhafte Weiterbildungen der Erfindungen sind Gegenstand der Unteransprüche.

Die Erfindung wird nachfolgend anhand von Figurenbeschreibungen sowie dazugehörigen Zeitdiagrammen eingehender erläutert.

Es zeigen:
- Fig 1: ein Prinzipschaltbild,
- Fig 2: einen Impulsfahrplan und
- Fig 3: eine schaltungstechnische Ausgestaltung.

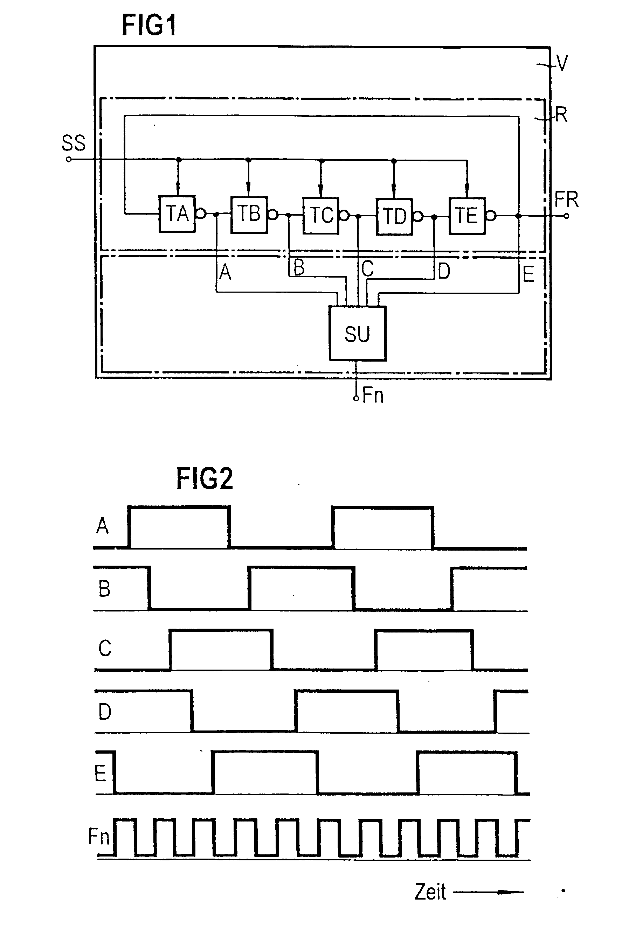

Fig 1. zeigt schematisch in einem zum Verständnis der Erfindung erforderlichem Umfang ein Prinzipschaltbild V. Das Prinzipschaltbild V ist in eine Schaltungseinheit mit einem Ringoszillator R und in eine Frequenzvervielfachende Schaltungseinheit SU untergliedert. Der in diesem Beispiel abgebildete Ringoszillator R wird aus einer Anzahl von in Reihe geschalteten invertierenden Signalverzögerungsstufen TA,...,TE gebildet. Der Ausgang E der letzten Signalverzögerungsstufe TE ist mit dem Eingang der ersten Signalverzögerungsstufe TA verbunden. Zur Steuerung der Weiterschaltung der an den Zeitverzögerungsgliedern TA,...,TE anliegenden Pegel der Eingangssignale werden die Steuereingänge der Signalverzögerungsglieder TA,...,TE mit einem Steuersignal SS gleichzeitig beaufschlagt. Mit diesem Steuersignal SS wird die Schwingfrequenz des Ringoszillators beeinflußt. Die an den Ausgängen der invertierenden Signalverzögerungsstufen anliegenden Signalpegel werden jeweils an den Eingang einer nachfolgenden Signalverzögerungsstufe weitergeleitet. Die Ausgänge der Signalverzögerungsstufen TA,...,TE, die in dieser Schaltungsanordnung mit A, B...., E bezeichnet sind, sind mit den Eingängen einer mit SU bezeichneten Summierschaltung verbunden. Die Frequenz des Pegelwechsels des Ausgangssignals des von der Summierschaltung SU erzeugten Ausgangssignals Fn ist ein Vielfaches von der am Ringoszillator R abgreifbaren Referenzfrequenz FR.

Das der Erfindung zugrundeliegende Stromsummationsprinzip eignet sich für beliebige ungeradzahlige Frequenz-Vervielfachungsfaktoren. In dem dargestellten Schaltungsbeipiel beträgt der Vervielfachungsfaktor 5.

Fig 2. zeigt die jeweils am Ausgang der Signalverzögerungsstufen TA,...,TE anliegenden logischen Pegel der Ausgangssignale. Dabei wird der am Ausgang einer Stufe anliegende Signalpegel jeweils zur nächsten Signalverzögerungsstufe TA,...,TE weitergeschaltet.

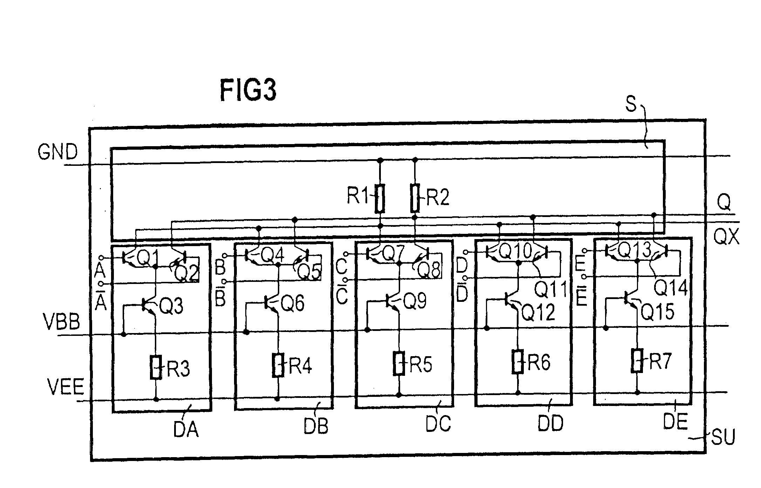

Fig 3. zeigt eine symmetrische Addierschaltung SU, die in differentieller CML-Schaltungslogik (Current Mode Logic) aufgebaut ist. Die Stromschalterlogik arbeitet bei dieser Schaltungsanordnung beispielsweise mit einem Hub von 200 mV und Strömen von jeweils 200 µA. Das logische 1-Potential an den Ausgängen der Differenzverstärker beträgt -2*200 mV, das logische 0-Potential -3*200 mV. Eine entsprechende Schaltung kann in einer SCF-Logik (Source-coupled FET Logic) aufgebaut werden. Die Ausgänge Q, QX der Differenzverstärker DA, DB,...,DE werden jeweils an einem Widerstand R1, R2 zusammengefaßt und an ein dem Erdpotential entsprechendes Betriebspotential gelegt.

## Patentansprüche

1. Schaltungsanordnung(V) zur Frequenzvervielfachung mit mehreren in Kaskade angeordneten Signalverzögerungsgliedern (TA,...,TE)zur sukzessiven Verzögerung eines an dem ersten Signalverzögersglied (TA) anliegenden Signals mit einer Summierschaltung (SU) zur Summierung der Ausgangssignale der einzelnen Signalverzögerungsglieder (TA,...,TE),
**dadurch gekennzeichnet**,
daß die Summierschaltung (SU) aus einer der Anzahl der Signalverzögerungsgliedern (TA,...,TB) entsprechenden Anzahl von Differenzverstärkern (DA,...,DE) gebildet ist,
daß den Eingängen der Differenzverstärker (DA,...,DE) jeweils die Ausgangssignale der jeweiligen Signalverzögerungsstufen (TA,...,TE) beaufschlagt werden,
und daß die homologen Ausgänge (Q1,Q2;...;Q13,Q14)aller Differenzverstärker (DA,...,DE) parallel geschaltet sind.

2. Schaltungsanordnung nach Anspruch 1,
**dadurch gekennzeichnet**,
daß die Signalverzögerungsglieder (TA,...,TB) einen Ringoszillator bilden.

3. Schaltungsanordnung nach Anspruch 2,
**dadurch gekennzeichnet**,
daß die Anzahl der Signalverzögerungsglieder ungeradzahlig ist.

4. Schaltungsanordnung nach Anspruch 1,
**dadurch gekennzeichnet**,
daß die homologen Ausgänge der Differenzverstärker (DA,...,DE) über ein Widerstandselement (R1, R2) mit einem dem Erdpotential entsprechendem Bezugspotential (GND) verbunden sind.

5. Schaltungsanordnung nach einem der vorhergehenden Ansprüche,
**dadurch gekennzeichnet**,
daß sie in Stromschaltertechnik, wie Current Mode Logic / Emitter Coupled Logic oder Source Coupled FET Logic auf einem Baustein integrierbar ist.

6. Schaltungsanordnung nach Anspruch 2,
**dadurch gekennzeichnet**,
daß die Schwingfrequenz(FR) des Ringoszillators(R) durch ein an die Signalverzögerungsglieder(TA,...,TE) des Ringoszillators anzulegendes Steuersignal(SS) steuerbar ist.

## Claims

1. Circuit arrangement (V) for frequency multiplication having a plurality of cascaded signal delay elements (TA, ..., TE) for successively delaying a signal present at the first signal delay element (TA) with a summing circuit (SU) for summing the output signals from the individual signal delay elements (TA, ..., TE), characterized in that the summing circuit (SU) is formed from a number of differential amplifiers (DA, ..., DE) which corresponds to the number of signal delay elements (TA, ..., TB), in that the inputs of the differential amplifiers (DA, ..., DE) each have the output signals from the respective signal delay stages (TA, ..., TE) applied to them, and in that the homologous outputs (Q1, Q2; ...; Q13, Q14) of all the differential amplifiers (DA, ..., DE) are connected in parallel.

2. Circuit arrangement according to Claim 1, characterized in that the signal delay elements (TA, ..., TB) form a ring oscillator.

3. Circuit arrangement according to Claim 2, characterized in that the number of signal delay elements is uneven.

4. Circuit arrangement according to Claim 1, characterized in that the homologous outputs of the differential amplifiers (DA, ..., DE) are connected via a resistor element (R1, R2) to a reference-earth potential (GND) corresponding to earth potential.

5. Circuit arrangement according to one of the preceding claims, characterized in that it can be integrated on a chip using current mode logic technology, such as current mode logic / emitter-coupled logic or source-coupled FET logic.

6. Circuit arrangement according to Claim 2, characterized in that the oscillating frequency (FR) of the ring oscillator (R) can be controlled by a control signal (SS) which can be applied to the signal delay elements (TA, ..., TE) of the ring oscillator.

## Revendications

1. Circuit (V) pour la multiplication de fréquence avec plusieurs éléments temporisateurs disposés en cascade (TA, ..., TE) pour la temporisation successive d'un signal appliqué sur le premier élément de temporisation (TA) avec un circuit additionneur (SU) pour l'addition des signaux de sortie des différents éléments temporisateurs (TA, .... TE)
**caractérisé par le fait**
que le circuit additionneur (SU) est formé par un nombre d'amplificateurs différentiels (DA, ..., DE) correspondant au nombre d'éléments temporisateurs (TA, ..., TE),
que les signaux de sortie de chaque étage temporisateur (TA, ..., TE) sont appliqués respectivement aux entrées des amplificateurs différentiels (DA, ..., DE)
et que les sorties homologues (Q1, Q2; ...; Q13, Q14) de tous les amplificateurs différentiels (DA, ..., DE) sont connectées en parallèle.

2. Circuit selon la revendication 1
**caractérisé par le fait**
que les éléments temporisateurs (TA, ..., TE) forment un oscillateur annulaire.

3. Circuit selon la revendication 2
**caractérisé par le fait**
que le nombre des éléments temporisateurs est impair.

4. Circuit selon la revendication 1
**caractérisé par le fait**
que les sorties homologues des amplificateurs différentiels (DA, ..., DE) sont reliées, par l'intermédiaire d'une résistance (R1, R2) à un potentiel de référence (GND) correspondant au potentiel de terre.

5. Circuit selon l'une des revendications précédentes
**caractérisé par le fait**
qu'il peut être intégré sur un module selon la technique de commutation en courant, comme la logique en mode courant, la logique à émetteur couplé ou la logique FET à sources couplées.

6. Circuit selon la revendication 2
**caractérisé par le fait**
que la fréquence (FR) de l'oscillateur annulaire (R) peut être commandée par un signal de commande (SS) qu'il faut appliquer sur les éléments temporisateurs (TA, ..., TE) de l'oscillateur annulaire.
